(19) Europäisches Patentamt
European Patent Office
Office européen des brevets

(11) **EP 2 765 599 A1**

(12) **DEMANDE DE BREVET EUROPEEN**

(43) Date de publication:
**13.08.2014 Bulletin 2014/33**

(21) Numéro de dépôt: **14154715.8**

(22) Date de dépôt: **11.02.2014**

(51) Int Cl.:
*H01L 21/84* (2006.01)          *H01L 29/786* (2006.01)
*H01L 21/762* (2006.01)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**

(30) Priorité: **11.02.2013 FR 1351142**

(71) Demandeurs:
• **COMMISSARIAT A L'ENERGIE ATOMIQUE ET AUX**
**ENERGIES ALTERNATIVES**
**75015 Paris (FR)**
• **STMicroelectronics (Crolles 2) SAS**
**38920 Crolles (FR)**
• **STmicroelectronics SA**
**92120 Montrouge (FR)**

(72) Inventeurs:
• **Niebojewski, Heimanu**
**38000 Grenoble (FR)**
• **Morand, Yves**
**38000 Grenoble (FR)**
• **Vinet, Maud**
**38140 Rives (FR)**

(74) Mandataire: **Hautier, Nicolas**
**Cabinet Hautier**
**20, rue de la Liberté**
**06000 Nice (FR)**

(54)     **Procédé de fabrication d'un transistor**

(57)     L'invention porte sur un procédé de fabrication d'un transistor comprenant la préparation d'un empilement de couches de type semi-conducteur sur isolant comportant au moins un substrat (112) sur lequel est disposé successivement une couche isolante (114) et une couche semi-conductrice initiale (312), caractérisé en ce qu'il comprend :
- la formation d'au moins un plot d'oxyde (311) s'étendant depuis une face supérieure de la couche isolante (114), la formation d'au moins un plot d'oxyde (311) comprenant les étapes suivantes :
• la formation d'au moins une cavité dans la couche semi-conductrice initiale (312) par gravure ;
• la formation d'une couche d'oxyde en surface dudit empilement de couches SOI réalisée de manière à ce que dans le fond des cavités le film d'oxyde formé s'étende au moins jusqu'à la couche isolante (114) ;
• un retrait partiel du film d'oxyde de manière à mettre à nu la couche semi-conductrice initiale (312) en dehors de la cavité et à conserver une partie au moins du film d'oxyde dans la cavité pour laisser en place un plot d'oxyde (311) s'étendant depuis la couche isolante (114);

- la formation d'une couche additionnelle en matériau semi-conducteur (313) recouvrant le plot d'oxyde 311 et destinée à former un canal pour le transistor ;
- la formation d'un empilement de grille à l'aplomb du plot d'oxyde (311);
- la formation d'une source et d'un drain de part et d'autre du plot d'oxyde.

FIGURE 8

EP 2 765 599 A1

**Description**

DOMAINE TECHNIQUE DE L'INVENTION

La présente invention concerne en général les transistors de type métal oxyde semi-conducteur à effet de champs (MOSFET) et plus particulièrement la réduction d'éléments parasites limitant leur vitesse de fonctionnement.

ÉTAT DE LA TECHNIQUE

Dans un transistor MOSFET on fait circuler un courant entre une électrode « source » et une électrode « drain » sous le contrôle d'une « grille » de commande qui crée un canal de conduction entre source et drain dès qu'une tension suffisante y est appliquée. La vitesse de commutation maximale d'un transistor MOSFET dépend de la vitesse avec laquelle on peut effectivement établir et faire disparaître le courant de conduction. Elle dépend, entre autres, de nombreux paramètres physiques propres aux matériaux utilisés comme, par exemple, la mobilité des porteurs du matériau semi-conducteur employé et les niveaux et type de dopage des différentes zones définissant les électrodes. La vitesse de commutation dépend aussi largement de la géométrie et de la structure des transistors. Notamment, par l'intermédiaire des éléments parasites qui sont inévitablement introduits par la réalisation pratique de ces dispositifs. Deux éléments parasites particulièrement critiques sont, d'une part, la résistance série d'accès des électrodes source et drain, et la capacité parasite entre grille et source ou drain d'autre part. Ces éléments parasites forment une constante de temps qui contribue à limiter la vitesse de commutation maximale de tout transistor.

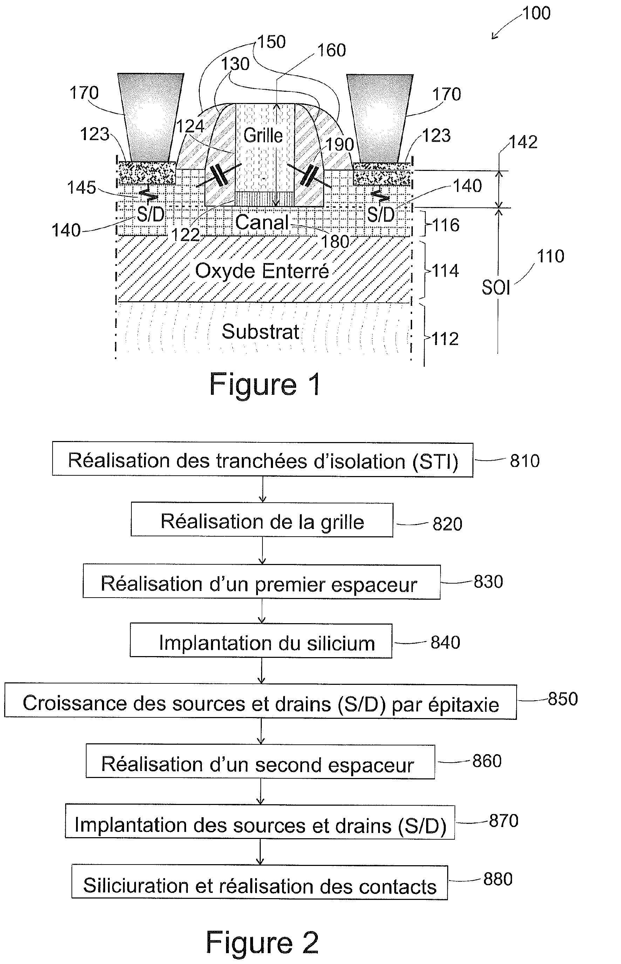

La **figure 1** montre une vue en coupe d'un transistor MOSFET 100 caractéristique de l'état actuel de la technique. Les circuits intégrés peuvent être réalisés à partir de substrats élaborés de type dit SOI, acronyme de l'anglais « silicon on insulator », c'est-à-dire « silicium sur isolant » et plus généralement « semi-conducteur sur isolant ». Dans la figure 1 on retrouve le substrat SOI 110 d'origine qui est constitué d'un substrat initial 112, le plus souvent une tranche homogène de silicium, et d'une couche d'oxyde enterrée 114 qui assure l'isolation des composants qui seront fabriqués dans la fine couche superficielle 116 de semi-conducteur présente sur la couche enterrée. La couche superficielle 116 est constituée le plus souvent du silicium monocristallin. L'isolation de chacun des transistors 100 est complétée par la réalisation de tranchées latérales d'isolation dites STI, acronyme de l'anglais « shallow trench isolation » c'est-à-dire « tranchées d'isolation peu profondes ». Elles atteignent la couche d'oxyde enterrée pour englober chacun des transistors dans une couche continue d'oxyde. Ces tranchées, qui ne sont pas nécessaires à la compréhension de l'invention, ne sont pas représentées.

La **figure 2** résume les principales étapes standard de fabrication d'un transistor MOSFET représentatif de l'état de la technique. La première étape 810 consiste à réaliser, à partir du substrat SOI 110 d'origine, les tranchées d'isolation STI mentionnées ci-dessus qui vont permettre d'assurer l'isolation complète de chacun des transistors 100. À l'étape globale suivante 820 on réalise l'empilement de couches et les motifs qui vont constituer l'empilement de grille 160 de chaque transistor comprenant deux couches essentielles : l'oxyde mince de grille 122 et la grille de commande 124 proprement dite. Cette dernière est généralement faite de silicium polycristallin conducteur qui joue le rôle du métal dans la structure MOS du transistor ou d'un empilement de couches constitué d'un métal et de polysilicium. À l'étape suivante 830, on réalise une première couche d'espaceurs 130 sur les flancs de chaque motif de grille. Les espaceurs, faits de nitrure de silicium, et la grille elle-même, vont servir à protéger le canal 180 lors d'une première opération d'implantation de la couche superficielle de silicium qui va suivre. On notera ici que les espaceurs et les sources et drains sont réalisés sans mettre en oeuvre aucune opération de photolithographie. Comme mentionné ci-dessus une première implantation 840 des zones de source et drain 140 dans la couche superficielle 116, généralement faite de silicium monocristallin, est ensuite effectuée. On remarquera que les sources et drains sont identiques, ils ont une même structure physique et géométrique. Seules leurs interconnexions avec d'autres transistors et les tensions qui seront appliquées dans le dispositif électronique en cours de réalisation vont pouvoir permettre d'attribuer finalement le rôle de source ou de drain à l'une ou l'autre des électrodes. Dans la description qui suit de l'invention les électrodes source et drain sont donc indifférenciées et référencées par un même acronyme « S/D » 140.

L'étape suivante 850 consiste à accroître l'épaisseur 142 des zones source et drain (S/D). Opération dont le but principal est de réduire les résistances 145 d'accès de ces électrodes. L'épaississement des zones S/D se fait classiquement par croissance épitaxiale à partir de la couche sous jacente, c'est-à-dire la couche 116 de silicium monocristallin du substrat SOI d'origine. Il s'agit donc de diminuer l'un des éléments parasites mentionnés précédemment qui viennent limiter la vitesse de commutation et les performances des transistors. Comme on constate que la résistance d'accès est inversement proportionnelle à l'épaisseur des S/D on notera ici qu'il y a tout intérêt pour réduire significativement cet élément parasite à augmenter la surélévation des S/D. Ce type de transistor et de procédé est souvent qualifié de « RSD », acronyme de l'anglais « raised source drain » c'est-à-dire « source drain surélevés ».

Les autres opérations standard consistent en une étape 860 de réalisation d'une seconde couche d'espaceurs 150. Cette seconde couche d'espaceurs sert à limiter latéralement, autour du motif de grille, les zones de siliciuration qui permettent d'assurer un bon contact électrique avec le silicium des S/D 140 surélevés. La siliciuration 123 et les contacts métalliques 170 sont formés à l'étape 880. Préalablement, à l'étape 870, une seconde implantation des S/D est réalisée qui assure un dopage de ces zones. Comme pour les S/D on notera qu'une siliciuration de la partie haute de l'empilement de grille 160 faite de silicium polycristallin est également réalisée pour qu'on puisse aussi établir un bon contact électrique sur cette électrode. Par souci de clarté le contact de grille et sa zone siliciurée ne sont cependant pas représentés sur la figure 1.

L'autre élément parasite mentionné précédemment est la capacité 190 entre les S/D et la grille. Les espaceurs constituent le diélectrique de cette capacité. La capacité parasite due aux espaceurs tend à augmenter proportionnellement à l'accroissement d'épaisseur 142 de la couche épitaxiale de surélévation des S/D 140. On constate ainsi que dans le procédé standard de réalisation des MOSFET qui vient d'être brièvement décrit, les conditions d'optimisation des éléments parasites principaux qui limitent leur vitesse de commutation sont parfaitement antagonistes puisque que pour diminuer l'un, la résistance d'accès des source et drain 140, il faut augmenter la surélévation de ces derniers ce qui entraîne une augmentation de l'autre élément parasite, c'est-à-dire la capacité 190 entre la grille et les S/D 140.

Pour compenser l'augmentation de la capacité parasite entre la grille et les S/D 140, différentes techniques ont été proposées. Une première méthode consiste à utiliser des espaceurs dont le matériau est à plus faible permittivité que celui du nitrure de silicium actuellement utilisé. Par exemple, le remplacement du nitrure par de l'oxyde de silicium permet de réduire significativement la valeur de la capacité parasite.

Le remplacement du nitrure complique cependant sérieusement le procédé standard de fabrication des transistors MOSFET.

Le procédé standard peut aussi être modifié en prévoyant d'utiliser directement des espaceurs en oxyde de silicium. Ce matériau se prête cependant beaucoup moins bien que le nitrure à la réalisation des espaceurs et il n'existe pas actuellement de procédé industriellement fiable qui permette un remplacement direct du nitrure.

Une méthode qui a été expérimentée consiste en ce que la croissance épitaxiale qui permet l'obtention d'une source et d'un drain surélevés afin de diminuer la résistance d'accès de ces électrodes, soit réalisée en limitant la croissance latérale de cette épitaxie afin d'éloigner zones S/D 140 de la grille et donc de diminuer une capacité parasite 190 en augmentant l'épaisseur de diélectrique entre ces zones. Cette technique dite « épitaxie facettée » est cependant particulièrement difficile à maîtriser. L'épaisseur de silicium déposée lors de la croissance d'une épitaxie facettée est très sensible à l'environnement. Ainsi, il y a des disparités d'épaisseur entre dispositifs larges et étroits qui peuvent induire des dysfonctionnements comme une siliciuration totale et l'apparition de courants de fuite qui nuisent gravement à la fiabilité des dispositifs. On constate également des disparités d'épaisseur entre les zones où la densité de motifs est grande et celles où elle est faible.

De cette brève présentation des procédés connus de réalisation des transistors MOSFET, il ressort qu'il n'existe pas de procédés simples et fiables qui permettent de réduire à la fois la résistance d'accès des électrodes source et drain et à la fois la capacité parasite entre ces électrodes et la grille de commande.

La présente invention a pour objectif de proposer une solution qui réponde à certaines au moins de ces contraintes. Les autres objets, caractéristiques et avantages de la présente invention apparaîtront à l'examen de la description suivante et des dessins d'accompagnement. Il est entendu que d'autres avantages peuvent être incorporés.

RÉSUMÉ DE L'INVENTION

Selon un mode de réalisation, la présente invention propose un procédé de fabrication d'un transistor comprenant la préparation d'un empilement de couches SOI de type semi-conducteur sur isolant comportant au moins un substrat sur lequel est disposé successivement une couche isolante et une couche semi-conductrice initiale, le procédé comprenant:

- la formation d'au moins un plot d'oxyde s'étendant depuis une face supérieure de la couche isolante, la formation d'au moins un plot d'oxyde comprenant les étapes suivantes :

  • la formation d'au moins une cavité dans la couche semi-conductrice initiale par gravure ;
  • la formation d'une couche d'oxyde en surface dudit empilement de couches réalisé de manière à ce que dans le fond des cavités le film d'oxyde formé s'étende au moins jusqu'à la face supérieure de la couche isolante ; Ainsi, le film d'oxyde et la couche isolante initiale forment une couche électriquement isolante ininterrompue ;
  • un retrait partiel du film d'oxyde de manière à mettre à nu la couche semi-conductrice initiale en dehors de la cavité et à conserver une partie au moins du film d'oxyde dans la cavité pour laisser en place un plot d'oxyde s'étendant depuis la couche isolante;

- la formation d'une couche additionnelle en matériau semi-conducteur recouvrant la couche semi-conductrice initiale et le plot d'oxyde et destinée à former un canal pour le transistor ;

- la formation d'un empilement de grille au dessus du plot d'oxyde;
- la formation d'une source et d'un drain de part et d'autre de l'empilement de grille.

L'invention propose ainsi un procédé particulièrement simple pour former des source et drain situés en partie au moins sous la grille, en formant des plots d'oxyde sur la couche isolante (typiquement une couche d'oxyde enterré) pour former une couche isolante continue, en formant un canal sur les plots d'oxyde et en formant une grille sur chacun de ces plots d'oxyde.

A la fois la source et le drain s'étendent en grande partie au moins de part et d'autre du plot d'oxyde formant un relief en saillie et sous la grille. Ainsi, le transistor présente une structure très particulière dans laquelle la source et/ou le drain sont inversés par rapport aux structures connues, c'est-à-dire qu'ils sont situés sous la grille. Cette structure permet de réduire la capacité parasite entre la grille et la source le drain. En outre elle permet d'épaissir la source et le drain selon une direction perpendiculaire au plan du substrat ce qui a pour effet de réduire la résistance d'accès des électrodes de la source et du drain.

De manière également avantageuse, l'invention permet de rendre indépendante la hauteur de la grille par rapport à la hauteur des source et drain, ce qui permet notamment de réduire la hauteur de la grille.

La présente invention est particulièrement adaptée pour les substrats de type semi-conducteur sur isolant, tels que les substrats élaborés de type silicium-sur- isolant (SOI) avec une couche enterrée d'oxyde (Buried Insulating Oxide, BOX) mince. En effet, grâce à l'invention l'épaisseur de la couche isolante initiale est conservée, aucune gravure de la BOX initiale n'étant nécessaire pour l'obtention de source et drain enterrés. L'invention a donc pour avantage d'être compatible avec un substrat intégrant une couche BOX mince ou épaisse.

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La FIGURE 1 montre une vue en coupe d'un transistor MOSFET caractéristique de l'état de la technique.

La FIGURE 2 résume les principales étapes standard de fabrication d'un transistor MOSFET représentatif de l'état de la technique.

La FIGURE 3 résume les principales étapes de fabrication d'un transistor selon des exemples de mode de réalisation de l'invention.

Les FIGURES 4a, 4b illustrent les structures obtenues à l'issue de deux modes de réalisation de l'étape de formation d'une cavité dans une couche semi-conductrice initiale.

La FIGURE 5 illustre la structure obtenue à l'issue de l'étape de formation d'un film d'oxyde continu par oxydation de la couche semi-conductrice initiale.

La FIGURE 6 illustre la structure obtenue à l'issue de l'étape de mise à nu de la couche semi-conductrice initiale en laissant en place un plot d'oxyde situé sur la couche isolante.

Les FIGURES 7a à 7c illustrent la structure obtenue à l'issue des étapes de formation d'une couche de matériau semi-conducteur recouvrant le plot d'oxyde.

La FIGURE 8 illustre la structure obtenue à l'issue de l'étape de formation d'un empilement de grille à l'aplomb du plot d'oxyde et sur la couche de matériau semi-conducteur.

La FIGURE 9 illustre la structure obtenue à l'issue de l'étape de formation d'espaceurs recouvrant les flancs de l'empilement de grille.

Les FIGURES 10a et 10b illustrent un mode de réalisation des source et drain comprenant un dopage de la couche semi-conductrice.

Les FIGURES 11a et 11b illustrent un autre mode de réalisation des source et drain comprenant une gravure de toute l'épaisseur du matériau semi-conducteur et la formation des source et drain par épitaxie à partir du canal.

Les FIGURES 12a et 12b illustrent un autre mode de réalisation des source et drain comprenant une gravure partielle du matériau semi-conducteur et la formation des source et drain par épitaxie.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :

Avantageusement, la formation du plot d'oxyde est effectuée de manière à ce que la largeur L du plot d'oxyde soit supérieure ou égale à la largeur Lg de l'empilement de grille.

Avantageusement, l'empilement de grille est formé par lithographie et la formation du plot d'oxyde est effectuée de manière à ce que : $L \geq Lg + 2 \times Des$, L étant la largeur L du plot d'oxyde, Lg étant la largeur de l'empilement de grille et Des étant l'imprécision maximale de désalignement de la lithographie. Cela permet de s'assurer que la grille est toujours entièrement située au dessus du plot d'oxyde sans dépasser les extrémités dudit plot d'oxyde malgré l'éventuel désalignement involontaire de la lithographie pour former la grille.

Ces largeurs sont prises selon une direction parallèle au plan du substrat et selon la direction de déplacement des électrons dans le canal, c'est-à-dire sur les figures selon la direction horizontale contenue dans le plan de la section représentée.

Avantageusement, le procédé comprend une étape de formation d'espaceurs sur les flancs de l'empilement de grille et la formation du plot d'oxyde est effectuée de manière à ce que : $Lg + 2 \times Lsp \geq L$, L étant la largeur L du plot d'oxyde, Lg étant la largeur de l'empilement de grille et Lsp étant la largeur de la couche des espaceurs.

Avantageusement, le retrait partiel du film d'oxyde effectué de manière à mettre à nu la couche semi-conductrice initiale en dehors de la cavité et à conserver une partie au moins du film d'oxyde dans la cavité comprend une étape de polissage de type mécanique et chimique (CMP, acronyme de l'anglais « Chemical-Mechanical Planarization ») avec arrêt sur la couche semi-conductrice initiale.

La couche additionnelle en matériau semi-conducteur recouvrant le plot d'oxyde et destinée à former un canal pour le transistor est une couche de matériau semi-conducteur cristallin. De préférence, elle est en matériau semi-conducteur monocristallin.

Avantageusement, la formation d'une couche additionnelle en matériau semi-conducteur recouvrant le plot d'oxyde et destinée à former un canal pour le transistor comprend le report d'une couche de matériau semi-conducteur cristallin sur le plot d'oxyde. De préférence, le report de la couche de matériau semi-conducteur est effectué par un procédé comprenant le détachement d'un film mince de matériau semi-conducteur monocristallin par rupture d'une couche plus épaisse au niveau d'une zone de fragilisation. L'homme du métier pourra se référer pour cela aux nombreux procédés connus de report d'une couche par collage moléculaire.

Selon un autre mode de réalisation, la couche semi-conductrice initiale est cristalline, de préférence monocristalline, et la formation d'une couche additionnelle en matériau semi-conducteur recouvrant le plot d'oxyde et destinée à former un canal pour le transistor comprend :

- le dépôt d'une couche de matériau semi-conducteur amorphe sur la couche semi-conductrice initiale et le plot d'oxyde,
- un traitement thermique effectué de manière à cristalliser la couche de matériau semi-conducteur amorphe par épitaxie en phase solide à partir de la couche semi-conductrice initiale.

Selon un mode de réalisation, la formation d'une source et d'un drain comprend le dopage de zones de source de part et d'autre de l'empilement de grille. Ce mode de réalisation est particulièrement avantageux dans le cas où l'épaisseur du canal est tellement mince qu'il devient difficile de réaliser des source et drain par épitaxie. En outre, ce mode de réalisation est particulièrement avantageux si l'on souhaite que le matériau semi-conducteur des source et drain soit le même que celui du canal.

De manière alternative, la formation d'une source et d'un drain comprend : une gravure d'au moins la couche additionnelle en matériau semi-conducteur de manière à retirer au moins une portion de l'épaisseur de la couche additionnelle en matériau semi-conducteur qui n'est pas située sous l'empilement de grille et de manière à conserver une partie au moins de la couche additionnelle en matériau semi-conducteur au niveau du canal du transistor; une croissance des zones de source et drain par épitaxie à partir du matériau semi-conducteur formant le canal. Ainsi, la gravure reforme une cavité de chaque côté de l'empilement de grille et la croissance par épitaxie forme les zones de source et drain dans ces cavités reformées.

De préférence, la formation d'une source et d'un drain comprend en outre le dopage des zones de source et drain au cours de l'étape de croissance des zones de source et drain par épitaxie.

Ce mode de réalisation est particulièrement avantageux lorsque l'on souhaite que le matériau dans les zones de source et drain soient différents de celui du canal. De préférence, les matériaux utilisés pour le canal d'une part et pour les zones de source et drain présentent, par exemple, des paramètres de maille qui diffèrent de moins de 1 % et de préférence de moins de 0.5% dans le plan parallèle à la face du substrat.

Ladite gravure d'au moins la couche additionnelle en matériau semi-conducteur est une gravure anisotrope dont la direction privilégiée de gravure est perpendiculaire au plan du substrat. Ladite gravure peut être fortement anisotrope, c'est-à-dire que pour une dimension gravée selon la direction perpendiculaire au plan du substrat, une dimension nulle ou bien plus faible sera gravée selon une direction parallèle au plan du substrat. Ladite peut également être faiblement anisotrope, c'est-à-dire que pour une dimension gravée selon la direction perpendiculaire au plan du substrat, une dimension plus faible sera gravée selon une direction parallèle au plan du substrat. Alternativement, la gravure est isotrope.

Selon un premier mode de réalisation, ladite gravure d'au moins la couche additionnelle en matériau semi-conducteur retire, de part et d'autre de l'empilement de grille, toute l'épaisseur de la couche additionnelle en matériau semi-conducteur et toute l'épaisseur de la couche semi-conductrice initiale. De préférence, la gravure est arrêtée sur la couche isolante. Ainsi, la gravure met à nu, de part et d'autre de l'empilement de grille, la couche isolante. La formation des source et drain est effectuée par épitaxie à partir du matériau semi-conducteur restant en place. Cette épitaxie est préférentiellement dirigée vers le bas, c'est-à-dire depuis le canal et en direction du substrat.

Selon un deuxième mode de réalisation, ladite gravure conserve, de part et d'autre de l'empilement de grille, un film formé par une portion au moins de l'épaisseur de la couche semi-conductrice initiale et éventuellement par une portion de la couche additionnelle en matériau semi-conducteur. Ainsi la gravure est partielle en ce qu'elle ne met pas à nu, de part et d'autre de l'empilement de grille, la couche isolante. Avantageusement, dans ce cas, l'épitaxie est amorcée par les extrémités latérales du canal et/ou par le film en matériau semi-conducteur laissé en place, de part et d'autre de l'empilement de grille, sur la couche isolante à l'issue de la gravure. Typiquement, seule une portion supérieure de l'ensemble formé par la couche additionnelle en matériau semi-conducteur et de la couche semi-conductrice initiale est retirée. Ladite portion supérieure enlevée par gravure anisotrope présente typiquement une épaisseur comprise entre 1 nm et 20 nm.

Selon un premier mode de réalisation, la formation d'au moins une cavité est réalisée par gravure d'une partie seulement de l'épaisseur de la couche semi-conductrice initiale dans le fond des cavités de manière à conserver une couche semi-conductrice ininterrompue à la surface de la couche isolante. Ainsi, la couche isolante n'est pas mise à nu dans le fond des cavités. Avantageusement, cela permet de stopper la gravure avant d'atteindre la couche isolante ce qui permet de réduire le temps de gravure.

De préférence, la formation d'une couche d'oxyde en surface dudit empilement de couches de type semi-conducteur sur isolant est réalisée par oxydation de la couche semi-conductrice initiale pour former un film d'oxyde continu sur la surface découverte de la couche semi-conductrice initiale. Ce mode de réalisation permet d'obtenir un oxyde de très bonne qualité. Il offre également une très bonne continuation de l'isolation entre la couche isolante et le plot d'oxyde.

Selon un deuxième mode de réalisation, la formation d'au moins une cavité est réalisée par gravure de la totalité de l'épaisseur de la couche semi-conductrice initiale dans le fond des cavités. Ainsi, la couche isolante est mise à nu dans le fond des cavités.

Selon un mode de réalisation, la formation d'une source et d'un drain est effectuée de manière à former la source et le drain en partie au moins dans la cavité.

Selon un mode de réalisation, la formation d'une source et d'un drain est effectuée de manière à former la source et le drain en partie au moins de part et d'autre du plot d'oxyde.

De préférence, la formation d'une couche d'oxyde en surface dudit empilement de couches de type semi-conducteur sur isolant peut être réalisée par un dépôt d'oxyde sur la toute surface dudit empilement de couches. De préférence, l'épaisseur du dépôt d'oxyde est au moins égale à la profondeur de la cavité.

De préférence, la formation d'au moins une cavité dans la couche semi-conductrice initiale comprend, préalablement à la gravure partielle, une étape de lithographie pour protéger avec un masque les zones qui ne seront pas gravées.

De préférence, la formation d'au moins une cavité dans la couche semi-conductrice initiale par gravure de la couche semi-conductrice initiale comprend, préalablement à la gravure, une étape d'oxydation de la couche semi-conductrice initiale dans les zones à graver et sur une épaisseur correspondant à l'épaisseur à graver. Avantageusement, la cinétique de gravure de l'oxyde est très supérieure à celle du matériau semi-conducteur. L'étape d'oxydation permet ainsi de mieux contrôler l'épaisseur gravée et donc la profondeur des cavités. De manière alternative, on n'effectue pas d'étape d'oxydation préalablement à la gravure. La gravure est alors effectuée après la définition par lithographie des motifs définissant les cavités à graver.

De préférence, la gravure des cavités est effectuée par gravure ionique réactive (RIE).

Avantageusement, la couche active est une couche de matériau semi-conducteur à base de silicium ou de germanium.

La couche semi-conductrice initiale également désignée couche active de l'empilement semi-conducteur sur isolant est une couche en silicium, en en silicium-germanium, ou en matériaux des éléments des colonnes III/V de la classification périodique des éléments.

La couche additionnelle en matériau semi-conducteur est une couche en silicium, en germanium, en silicium-germanium ou en matériaux des éléments des colonnes III/V de la classification périodique des éléments.

De préférence, on prévoit pour la couche semi-conductrice initiale et la couche additionnelle en matériau semi-conducteur des matériaux identiques.

Alternativement, on peut prévoir des matériaux différents mais existant sous une forme cristalline compatible. Ainsi, les matériaux utilisés présentent, par exemple, des paramètres de maille qui diffèrent de moins de 1% et de préférence de moins de 0.5% dans le plan parallèle à la face du substrat. Cela est particulièrement avantageux pour faciliter la formation d'un canal cristallin et de préférence monocristallin par épitaxie par exemple.

De préférence, la couche isolante initiale est une couche d'oxyde enterrée de l'empilement de couches de type semi-conducteur sur isolant.

De préférence, la couche semi-conductrice initiale est la couche active de l'empilement de couches de type semi-conducteur sur isolant.

De préférence, le transistor est un transistor de type MOSFET (Transistor à effet de champ).

Il est précisé que dans le cadre de la présente invention, le terme « sur » « surmonte » ou « sous jacent » ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans le cadre de la présente invention on qualifie de largeur des dimensions prises selon une direction parallèle au plan de la face inférieure d'un substrat 112 et selon la direction de déplacement des électrons dans le canal. On qualifie d'épaisseur une dimension prise selon une direction perpendiculaire au plan de la face inférieure du substrat 112. Ainsi, sur les figures illustrées, la largeur L d'un plot d'oxyde 311, la largeur Lg d'un empilement de grille 160, et la largeur Lsp des espaceurs 410 sont prises selon une direction horizontale et les épaisseurs sont prises selon une direction verticale.

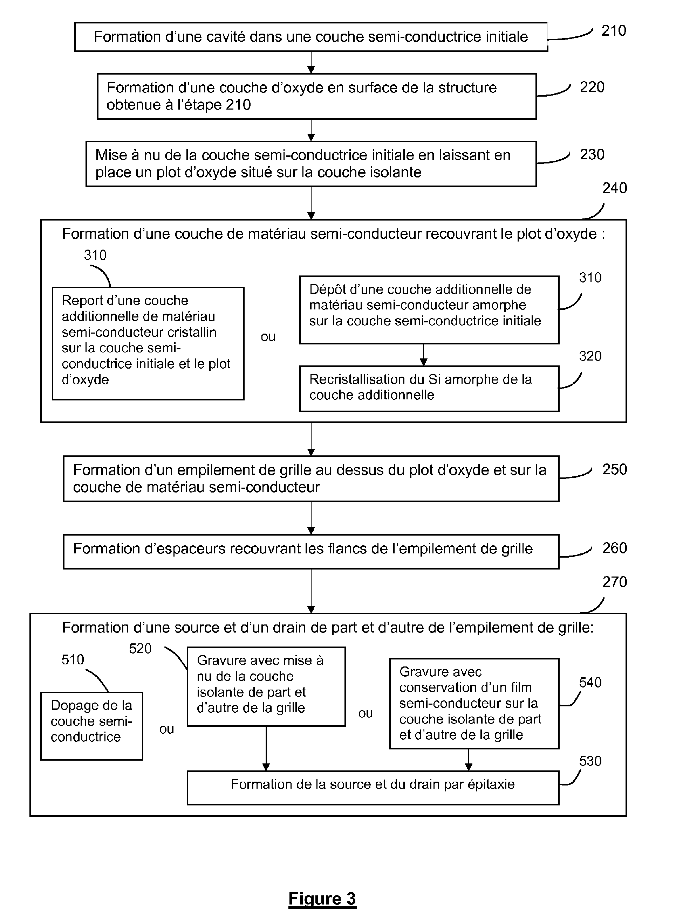

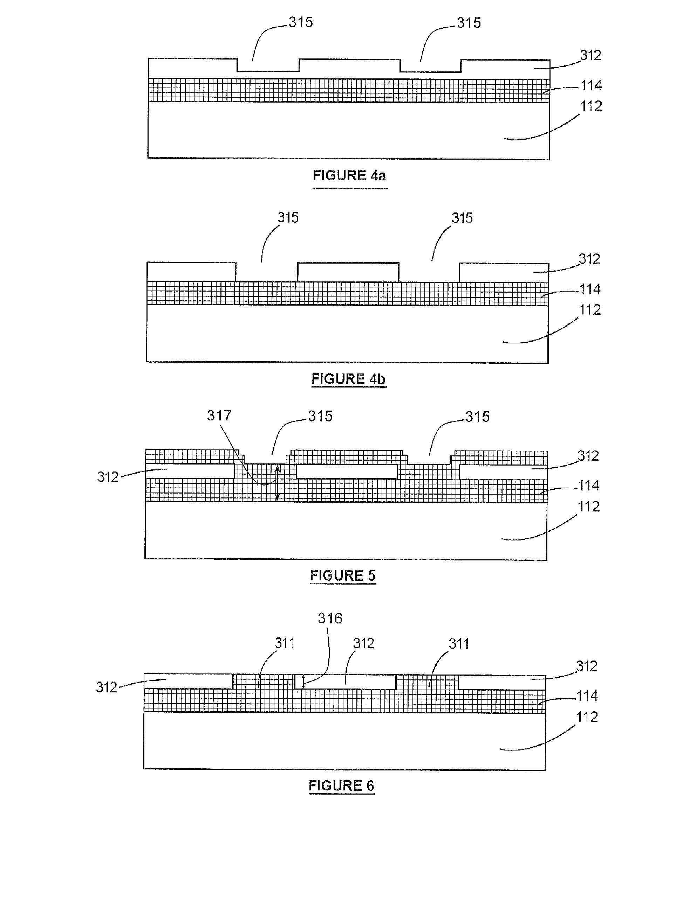

La **figure 3** résume les principales étapes de fabrication d'un transistor 200 selon un exemple de mode de réalisation de l'invention. Ces étapes seront décrites avec plus de détails en référence aux **figures 4a à 12b.** Seules deux transistors 200 seront illustrés sur ces figures afin de faciliter la compréhension de l'invention. Naturellement un nombre bien plus élevé de transistors peut être effectué lors d'un même procédé.

La structure de départ du procédé selon l'invention est une structure de type semi-conducteur sur isolant, par exemple de type SOI. Plus précisément, la structure comporte un substrat 112, une couche isolante 114 (mince ou épaisse), d'oxyde enterré et une couche semi-conductrice initiale 312 également qualifiée de couche mince et formant la couche active de l'empilement de type SOI. Avantageusement, l'épaisseur de la couche isolante 114 ne constitue pas une contrainte pour la réalisation de l'invention.

L'étape 210 consiste à former une cavité 315 pour chaque transistor 200 à réaliser. Cette cavité 315 peut être réalisée soit par gravure d'une portion seulement de l'épaisseur de la couche semi-conductrice initiale 312 dans le fond des cavités 315 (comme illustré en figure 4a) soit par gravure de la totalité de l'épaisseur de la couche semi-conductrice initiale 312 dans le fond des cavités 315 (comme illustré en figure 4b).

Dans le mode de réalisation de la gravure partielle, la profondeur de la cavité 315 est définie de manière à laisser en place du matériau semi-conducteur dans le fond des cavités 315, comme illustré en figure 4a. De préférence, une épaisseur de la couche semi-conductrice initiale 312 de l'ordre de 1 à plusieurs nm (nanomètre) est conservée dans le fond de cavité 315. Par exemple, pour obtenir un plot s'élevant de 15 nm (c'est-à-dire une différence de marche de 15 nm) au-dessus de la couche isolante 114 de l'empilement SOI, on peut laisser dans le fond des cavités 315 une épaisseur de matériau semi-conducteur de l'ordre de 6nm. La hauteur du plot d'oxyde 311 formé ultérieurement est référencée 316 en figure 6 décrite ci-dessous. Le matériau semi-conducteur est par exemple du silicium, du germanium ou du silicium-germanium.

Dans le mode de réalisation de la gravure totale des zones de la couche semi-conductrice initiale 312 destinée à former les cavité 315 (comme illustré en figure 4b), une gravure est réalisée pour enlever toute l'épaisseur de la couche semi-conductrice initiale 312 dans le fond des cavités 315. Ainsi, il ne reste plus de matériau de la couche semi-conductrice initiale 312 dans le fond des cavités 315 ; autrement dit, la surface supérieure de la couche isolante 114 au niveau des cavités 315 est mise à nu.

La hauteur du plot d'oxyde 311 formé ultérieurement est référencée 316 en figure 6 décrite ci-dessous. Le matériau semi-conducteur est par exemple du silicium, du germanium ou du silicium-germanium.

Pour réaliser les cavités 315 par gravure soit partielle soit totale des zones de la couche semi-conductrice initiale 312 destinées à former les cavités 315, on réalise au préalable une étape de lithographie pour former un masque recouvrant les zones que l'on ne souhaite pas graver, c'est-à-dire les zones en dehors des cavités 315.

La largeur de la cavité 315 conditionne celle du plot d'oxyde 311. Il se peut que les lithographies servant d'une part à former les cavités 315 et servant d'autre part à réaliser l'empilement de grille 160 présentent un désalignement. Dans le cadre de la présente invention, l'empilement de grille 160 doit être situé au dessus du plot d'oxyde 311 sans dépasser les extrémités dudit plot d'oxyde 311. On réalise donc la cavité 315 de manière à ce que sa largeur L soit supérieure à la largeur Lg de l'empilement de grille 160. Avantageusement, on applique la formule ci-dessous pour calculer le dimensionnement du plot d'oxyde 311 :

$$L \geq Lg + 2 \times \text{désalignement lithographique}$$

Selon un premier mode de réalisation, la gravure de la couche semi-conductrice initiale 312 est réalisée directement à travers le masque définissant les motifs des cavités.

Selon un autre mode de réalisation, la gravure de la couche semi-conductrice initiale 312 est réalisée après une oxydation de la couche semi-conductrice initiale 312 à travers le masque définissant les motifs des cavités. Cette étape d'oxydation oxyde ainsi les zones non protégées par le masque. Cette étape d'oxydation permet de contrôler très précisément l'épaisseur à graver, en tirant profit de la sélectivité à la gravure de l'oxyde par rapport au matériau semi-conducteur. L'épaisseur d'oxydation définit alors directement l'épaisseur des zones de la couche semi-conductrice initiale 312 à graver par la suite. On notera que l'oxydation tend à augmenter la taille des motifs à graver, il faut donc en prendre compte lors de l'étape de lithographie des cavités.

Dans ces deux modes de réalisation, la gravure est de préférence une gravure ionique réactive RIE (Reactive-Ion Etching en anglais). Elle est de préférence anisotrope dirigée perpendiculairement au plan du substrat 112.

La **figure 5** illustre la structure obtenue à l'issue de l'étape 220 de formation d'une couche d'oxyde électriquement isolante continue en surface de la structure obtenue après la réalisation de l'étape précédente 210. Selon la structure obtenue à l'issue de l'étape 210 (illustré en figures 4a, 4b), l'étape 220 peut être réalisée soit par oxydation de la couche semi-conductrice initiale 312, soit par un dépôt d'oxyde sur la toute surface de la structure obtenue à l'issue de l'étape 210.

Dans le cas où une épaisseur de la couche semi-conductrice initiale 312 est conservée dans le fond de cavité 315 (comme illustré en figure 4a), l'étape 220 consiste à effectuer une oxydation thermique pour former un film d'oxyde continu sur la surface découverte de la couche semi-conductrice initiale 312. Le masque ou la couche de résine utilisé pour former les cavités 315 aura préalablement été retiré.

Les paramètres d'oxydation, notamment la durée d'oxydation, sont à définir de manière à oxyder la totalité de la couche semi-conductrice initiale 312 en fond de cavité 315. Ainsi, toute la couche semi-conductrice initiale 312 présente sous les cavités 315 est oxydée. Le film d'oxyde formé dans le fond des cavités 315 s'étend donc jusqu'à la couche isolante 114. Il forme avec cette dernière une couche ininterrompue d'oxyde. Ainsi, toute l'épaisseur 317 est constituée par un matériau isolant, i.e., de l'oxyde. Au contraire, la couche semi-conductrice initiale 312 est divisée en plusieurs parties du fait de la présence des plots d'oxyde 311.

L'oxydation peut élargir la taille des cavités de la couche semi-conductrice initiale 312, ce qui ce n'est pas gênant en soi. Il faut alors simplement anticiper cela dès l'étape 210 pour calculer la largeur des motifs du masque et des cavités 315 à graver avant oxydation.

Alternativement, dans le cas où le fond de cavité 315 est mis à nu (comme illustré en figure 4b), l'étape 220 peut être également réalisée, comme illustré ci-dessus, par oxydation de la couche semi-conductrice initiale 312. Dans un autre mode de réalisation, l'étape 220 est réalisée par un dépôt d'oxyde sur toute la surface de la structure obtenue après la réalisation de l'étape 210. Dans ce cas, l'épaisseur déposée du dépôt d'oxyde est de préférence au moins égale à la profondeur de la cavité 315.

La **figure 6** illustre la structure obtenue à l'issue de l'étape 230 de mise à nu des portions de la couche semi-conductrice initiale 312, disposées entre les cavités 315. Cette étape 230 consiste à retirer les zones oxydées surmontant la couche semi-conductrice initiale 312 en réalisant un polissage, tel qu'un polissage mécano-chimique CMP. Le polissage CMP s'arrête sur la couche semi-conductrice initiale 312. Ainsi, après CMP il n'y a plus d'oxyde surmontant la couche semi-conductrice initiale 312. Seul demeurent les plots d'oxyde 311 formés au niveau des cavités 315. De préférence, l'épaisseur 316 est égale de celle de la couche semi-conductrice initiale 312 qui demeure après CMP.

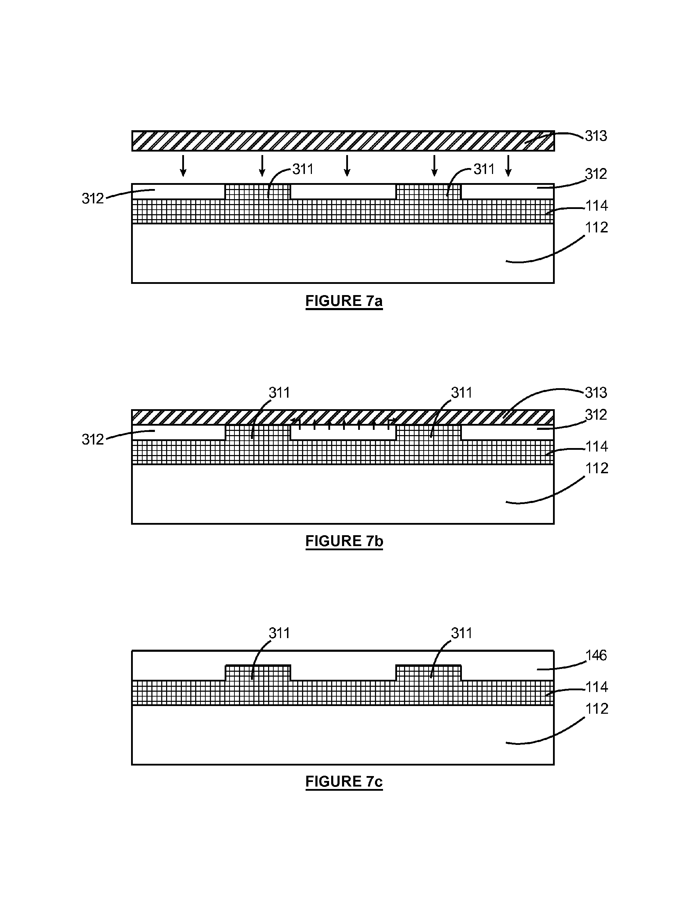

Ensuite, les **figures 7a à 7c** illustrent la structure obtenue à l'issue de l'étape 240 de formation d'une couche en matériau semi-conducteur recouvrant les plots d'oxyde 311.

Plus précisément, l'étape 240 comprend les étapes 310 et/ou 320 de formation d'une couche additionnelle en matériau semi-conducteur 313 sur les plots d'oxyde 311, cette couche additionnelle en matériau semi-conducteur 313 étant destinée à former le canal 180 de chaque transistor 200. Elle est également destinée à former une couche semi-conductrice ininterrompue 146 avec la couche semi-conductrice initiale 312. Deux modes de réalisation sont présentés par la suite. La **figure 7c** illustre la structure obtenue à l'issue de chacun de ces modes de réalisation.

L'étape 310, illustrée en **figure 7a,** consiste à déposer une couche additionnelle 313 de matériau semi-conducteur, avantageusement cristallin, en silicium par exemple. L'épaisseur de la couche additionnelle 313 est de préférence comprise entre 5 et 20 nm. De manière avantageuse, cette couche additionnelle 313 est reportée sur l'empilement comportant les plots d'oxyde 311 et la couche semi-conductrice initiale 312 depuis une autre structure, tel qu'un substrat donneur. Pour effectuer ce report, on peut par exemple utiliser la technique SMART CUT développée par la société SOITEC. Typiquement, la couche additionnelle 313 est un film mince que l'on détache d'un substrat donneur en ayant au préalable créé dans ce substrat donneur une zone de fragilisation, par exemple par implantation ionique.

Les portions de la couche semi-conductrice initiale 312 et la couche additionnelle en matériau semi-conducteur 313 forment une couche semi-conductrice ininterrompue 146, comme illustré en **figure 7c.**

De préférence, la couche semi-conductrice initiale 312 et la couche additionnelle en matériau semi-conducteur 313 sont monocristallines.

Optionnellement, on ajuste l'épaisseur de la couche semi-conductrice 146 en effectuant un polissage CMP. Avantageusement, on ajuste ainsi l'épaisseur du canal 180 formé par la portion de la couche additionnelle 313 située au-dessus du plot d'oxyde 311.

Ce mode de réalisation est particulièrement avantageux pour obtenir un canal monocristallin sans défaut dans la structure cristalline, y compris au milieu du canal 180. Le canal 180 est donc homogène et présente une structure cristalline sans défauts ou avec un nombre de défauts limité.

Selon l'autre méthode, la couche semi-conductrice ininterrompue 146 est reformée par épitaxie en phase solide, habituellement désignée par son vocable anglais « Solid Phase Epitaxy ». Le matériau semi-conducteur tel que déposé de la couche additionnelle 313 est alors amorphe (par exemple du silicium amorphe). Cette couche additionnelle 313 est déposée, à une température par exemple de 400°C, sur la face présentant les plots d'oxyde 311 et la couche semi-conductrice initiale 312.

La **figure 7b** illustre la structure obtenue au cours de l'étape 320 de recristallisation du matériau semi-conducteur de la couche additionnelle 313 amorphe, recristallisation amorcée par la structure cristalline de la couche semi-conductrice initiale 312. Dans le cas où ce matériau est du silicium amorphe, un traitement thermique est effectué à une température préférentielle de 500°C, pour qu'une recristallisation du silicium amorphe de la couche 313 soit amorcée par le matériau semi-conducteur cristallin de la couche 312. Ainsi, une couche semi-conductrice 146 cristalline est formée à partir de la couche 313 déposée à l'état amorphe et de la couche 312 cristalline, comme illustré en **figure 7c.** De préférence, la couche 312 est monocristalline et la couche semi-conductrice 146 obtenue après recristallisation de la couche 313 est également monocristalline.

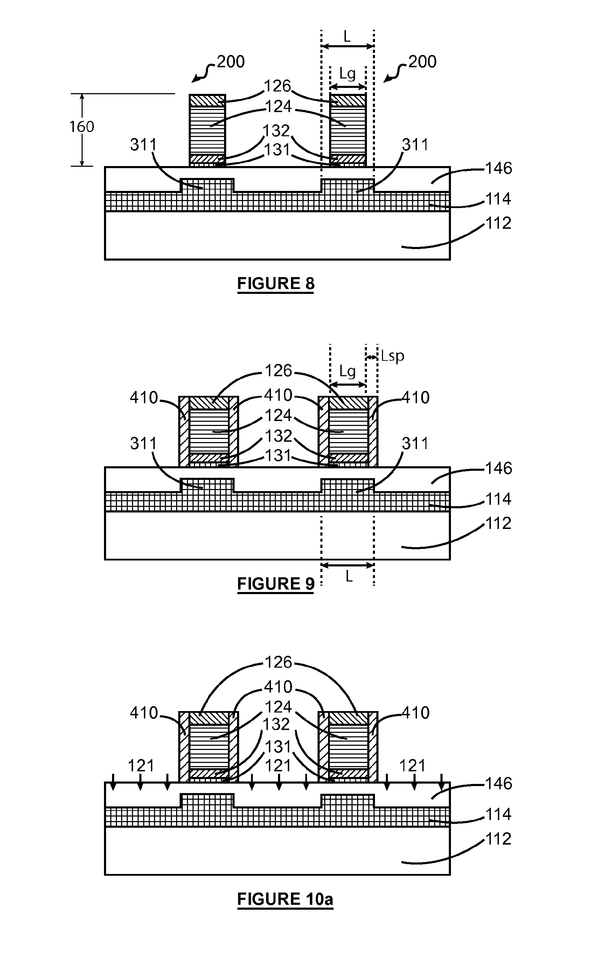

La **figure 8** illustre la structure obtenue à l'issue de l'étape 250 de formation d'un empilement de grille 160 à l'aplomb d'un plot d'oxyde 311. L'empilement 160 comporte par exemple les couches suivantes empilées depuis la couche semi-conductrice 146: une couche d'isolation de la grille, souvent désignée oxyde mince de grille 131 ou couche high-k, une couche métallique 132, la grille 124 également désignée électrode de grille et un masque dur 126 recouvrant la surface supérieure de la grille 124. L'invention n'est pas limitée à cet empilement de grille 160 et certaines des couches mentionnées ci-dessous peuvent ne pas être présentes ou d'autres couches peuvent être rajoutées sans pour autant sortir du cadre de la présente invention.

Comme mentionné précédemment à l'étape 210, chaque empilement de grille 160 est déposé au droit d'un plot d'oxyde 311 sans dépasser les extrémités dudit plot d'oxyde 311. La grille n'est pas forcement alignée avec le centre du plot. Afin d'éviter ou de réduire le désalignement des source et drain 140 par rapport à l'empilement de grille 160, on peut utiliser la formule suivante mentionnée précédemment afin de définir les largeurs de la grille et des cavités : $L \geq Lg + 2$ x désalignement lithographique maximum. En effet, le désalignement de l'empilement de grille 160 par rapport au plot d'oxyde 311 impacte de nombreux paramètres tels que la résistance série, le contrôle électrostatique du canal, la capacité parasite, la fuite, la vitesse, etc.

L'empilement de grille 160 est réalisé de manière conventionnelle, par exemple par une succession de lithographies et de gravures.

La **figure 9** illustre la structure obtenue à l'issue de l'étape 260 de formation de couches de protection recouvrant les flancs de l'empilement de grille 160. Ces couches de protection, habituellement désignées espaceurs 410, sont situées de part et d'autre de l'empilement de grille 160, s'étendent principalement perpendiculairement au plan du substrat 112 et recouvrent les flancs de la grille 124 au moins. Ils sont avantageusement faits de nitrure de silicium. Le masque dur 126 et les espaceurs 410 protègent l'empilement de grille 160 pour que les flancs de l'empilement de grille 160 ne soient pas gravés lors des opérations qui vont suivre. En particulier, comme cela apparaîtra dans la suite de la description, le masque dur 126 et les espaceurs 410 sont faits de matériaux résistant aux produits de gravure des cavités qui sont utilisés lors de l'étape 520 décrite ci-dessous.

De manière particulièrement avantageuse pour positionner l'empilement de grille 160 à l'aplomb du plot d'oxyde 311, on applique la condition suivante:

$$Lg + 2 \text{ x } Lsp \geq L,$$

dans laquelle Lsp avec est la largeur des espaceurs 410.

De plus, le désalignement maximum de l'empilement de grille 160, e.g. 3 à 4 nm, doit être inférieur à la largeur des espaceurs 410, e.g. 6 à 8 nm. Les extrémités des espaceurs 410 doivent surmonter les zones de forte épaisseur du matériau semi-conducteur de la couche semi-conductrice 146. Ainsi, les faces libres des espaceurs 410, i.e., celles tournées vers l'extérieur de l'empilement de grille 160, ne sont pas situées à l'aplomb d'un plot d'oxyde 311. En revanche, la grille 124 doit se situer à l'aplomb du plot d'oxyde 311, c'est-à-dire quelle que soit sa position au dessus du plot d'oxyde mais ses flancs ne devant pas dépasser des extrémités dudit plot d'oxyde 311.

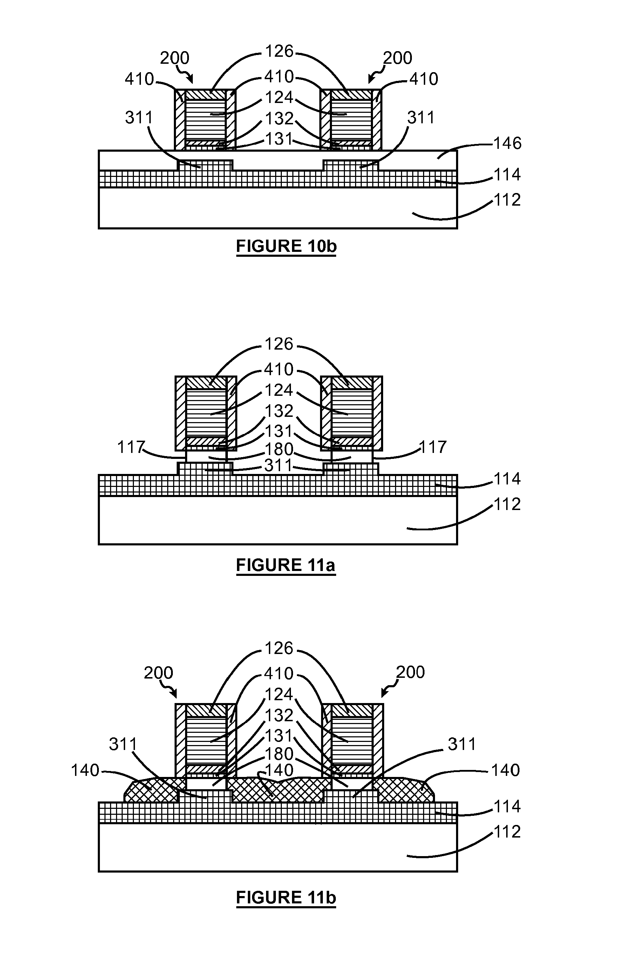

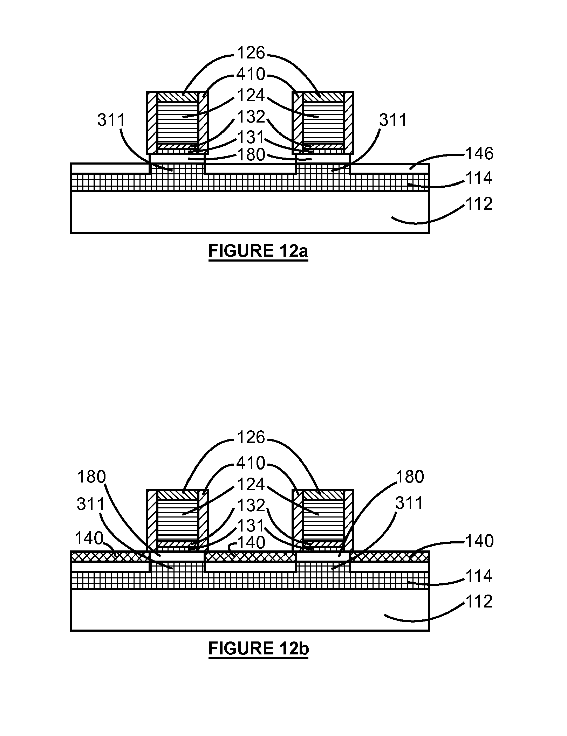

L'étape suivante 270 consiste à réaliser les zones de source et drain 140 et peut être réalisée par un des trois modes de réalisation 510, 520, 540 suivants respectivement illustrés en **figures 10a, 10b** (étape 510), en **figures 11a et 11b** (étape 520), et en **figures 12a, 12b** (étape 540).

Le premier mode de réalisation illustré en figures 10a et 10b est particulièrement avantageux si l'on souhaite que le matériau des source et drain 140 soit le même que celui du canal 180. Les deuxième et troisième modes de réalisation prévoient d'une part une gravure de la couche semi-conductrice 146 réalisée en conservant cette dernière au moins au niveau d'une zone formant le canal 180 et d'autre part une épitaxie à partir de cette zone. Cela offre la possibilité d'avoir des source et drain 140 dont le matériau peut être différent de celui du canal 180.

La **figure 10a** illustre la structure obtenue à l'issue de l'étape 510 de dopage de la couche semi-conductrice 146 reformée à partir des couches 312 et 313 et selon l'un des modes de réalisation de l'étape 240 illustrée en figure 3. Cette couche semi-conductrice 146 est dopée par implantation ionique 121 de part et d'autre de la grille 124 pour former les source et drain 140.

La structure 200 ainsi obtenue (illustrée en figure 10b) présente des source et drain 140 en contrebas des grilles 124. Les capacités parasites sont donc réduites alors même que l'épaisseur des source et drain 140 peut être librement adaptée pour réduire la résistance d'accès au transistor 200.

Le premier mode de réalisation de formation des source et drain 140 présente pour avantage d'être simple et indépendant de l'épaisseur du canal 180. Cela permet de former des source et drain 140 dans le cas où le canal 180 est tellement mince qu'il devient difficile de réaliser des source et drain 140 par épitaxie.

La **figure 11a** illustre la structure obtenue à l'issue de l'étape 520 de gravure de la totalité de l'épaisseur de la couche semi-conductrice 146 à l'exception des zones situées sous les grilles 124 et de définition du canal 180. Cette étape 520 est explicitée ci-dessous.

A l'issue de l'étape de formation de l'empilement de grille 160 et de l'étape préférentielle de formation des espaceurs 410, on effectue une gravure pour enlever, de part et d'autre de l'empilement de grille 160, toute l'épaisseur de la couche semi-conductrice 146 reformée tout en conservant toute l'épaisseur de cette couche semi-conductrice 146 sous la grille 124. Cette gravure est par exemple une gravure humide de type TMAH (« Tetramethylammonium Hydroxide »). De préférence, elle anisotrope et dirigée perpendiculairement à la surface du substrat 112. Selon un autre mode de réalisation, notamment si les espaceurs sont suffisamment larges par rapport à l'épaisseur de la couche 146, la gravure peut être faiblement anisotrope voire isotrope. Les zones de la couche semi-conductrice 146 situées en dessous de la grille 124 sont laissées en place de sorte à former le canal 180.

Sur l'exemple illustré en figure 11a, toute la couche semi-conductrice 146 est retirée à l'exception des zones situées sous les grilles 124.

De manière avantageuse, une épaisseur de la couche semi-conductrice 146 est retirée sous les espaceurs 410. De préférence, toute l'épaisseur de la couche semi-conductrice 146 située sous les espaceurs 410 est retirée. Les extrémités latérales du canal 180 sont ainsi mises à nu et les extrémités inférieures des espaceurs 410 forment un rebord au-dessus de chaque extrémité latérale du canal 180. L'intérêt de cette caractéristique pour favoriser une épitaxie dirigée vers le bas est détaillé par la suite. On qualifie d'extrémités latérales du canal 180 les extrémités qui apparaissent dans le plan des figures. Les extrémités latérales du canal 180 sont indiquées par la référence 117 sur la figure 11 a. Comme mentionné précédemment, l'empilement de grille 160, protégé par les espaceurs 410 et le masque dur 126, n'est pas gravé lors de la gravure de la couche semi-conductrice 146.

La **figure 11 b** illustre la structure obtenue à l'issue de l'étape 530 de formation des source et drain 140. Une épitaxie amorcée par le matériau semi-conducteur du canal 180 est effectuée pour remplir les volumes formés de part et d'autre de l'empilement de grille 160 et sous la grille 124.

De préférence, le canal 180 est un matériau semi-conducteur monocristallin.

On peut par exemple utiliser des matériaux identiques pour d'une part le canal 180 formé par la couche semi-conductrice 146 et pour d'autre part les zones de source et drain 140 formés par épitaxie. On peut par exemple utiliser du silicium ou d'autres matériaux semi-conducteurs aussi susceptibles d'être utilisés sous une forme monocristalline comme le germanium (Ge) ou des alliages de ces deux matériaux (Si-Ge).

Alternativement, ce mode de réalisation permet d'utiliser des matériaux différents pour le canal 180 formé par la couche semi-conductrice 146 et pour les zones de source et drain 140 formés par épitaxie. Ainsi, pour cette alternative on peut prévoir pour les zones de source et drain 140 un matériau différent de celui du canal 180 mais existant sous une forme cristalline adaptée au réseau cristallin du canal 180, c'est-à-dire qu'il présente, par exemple, des paramètres de maille qui diffèrent de moins de 1% et de préférence de moins de 0.5% de celui du matériau du canal 180 dans le plan parallèle à la face du substrat 112.

L'épitaxie, à partir des extrémités latérales du canal 180 mises à nu, se fait vers le bas en évitant que les zones de source et drain 140 ne viennent en regard de la grille 124. De plus, la présence des espaceurs 410 qui surplombent les extrémités latérales du canal 180 en formant un rebord au-dessus de ces dernières tend à empêcher l'épitaxie de remonter en direction de la grille 124. Les espaceurs 410 favorisent ainsi la croissance épitaxiale vers le bas.

De manière préférentielle, on effectue un dopage des régions de source et drain 140 simultanément à la croissance par épitaxie. Ce type de dopage est habituellement qualifié de dopage in-situ.

La **figure 12a** illustre la structure obtenue à l'issue de l'étape 540 de gravure partielle de la couche semi-conductrice 146 à l'exception des zones situées sous l'empilement de grille 160 et de définition du canal 180. Cette étape 540 est explicitée ci-dessous.

Comme illustré à l'étape 520 ci-dessus, l'épaisseur de la couche semi-conductrice 146 en dessous de l'empilement de grille 160 est entièrement conservée lors de la réalisation de l'étape 540 de sorte à former le canal 180. En revanche, un film de la couche semi-conductrice 146 est laissé en place sur la couche isolante 114 en dehors des zones situées au droit de l'empilement de grille 160, comme illustré en **figure 12a.** Ce film est constitué d'une partie au moins de la couche 312 et éventuellement d'une partie de l'épaisseur de la couche 313.

A cette fin, une gravure anisotrope, de préférence une gravure ionique réactive RIE, est réalisée pour enlever, de part et d'autre de l'empilement de grille 160, une portion de l'épaisseur de la couche semi-conductrice 146. Cette épaisseur est de préférence comprise entre 1 nm et 20 nm. De plus, comme mentionné précédemment, l'empilement de grille 160, protégé par les espaceurs 410 et le masque dur 126, n'est pas gravé lors de cette étape 540.

La **figure 12b** illustre la structure obtenue à l'issue de l'étape 530 de formation des source et drain 140. Les source et drain 140 sont formés par épitaxie. De manière avantageuse, on effectue un dopage des régions de source et drain 140 simultanément à la croissance par épitaxie. Ce type de dopage est habituellement qualifié de dopage in-situ.

L'épitaxie est amorcée au moins en partie par le film semi-conducteur laissé en place par la gravure partielle de la couche 146. Selon un autre mode de réalisation, l'épitaxie est amorcée par les extrémités latérales du canal. Selon un autre mode de réalisation, l'épitaxie est amorcée par les extrémités latérales du canal et par le film semi-conducteur laissé en place par la gravure partielle de la couche 146.

Dans tous les modes de réalisation décrits ci-dessus, l'épaisseur des zones de source et drain 140 peut être librement adaptée pour diminuer la résistance d'accès au transistor 200 tout en maintenant ces zones de source et drain 140 essentiellement et de préférence entièrement sous la grille 124, réduisant ainsi la capacité parasite.

De manière particulièrement avantageuse, les source et drain 140 sont auto-alignés avec la grille 124.

L'invention n'est pas limitée aux modes de réalisation précédemment décrits mais s'étend à tout mode de réalisation couverts par les revendications.

## Revendications

1. Procédé de fabrication d'un transistor (200) sur un empilement de couches de type semi-conducteur sur isolant comportant au moins un substrat (112) sur lequel est disposé successivement une couche isolante (114) et une couche semi-conductrice initiale (312), **caractérisé en ce qu'**il comprend :

    - la formation d'au moins un plot d'oxyde (311) s'étendant depuis une face supérieure de la couche isolante (114), la formation d'au moins un plot d'oxyde (311) comprenant les étapes suivantes :

        • la formation d'au moins une cavité (315) dans la couche semi-conductrice initiale (312) par gravure ;
        • la formation d'une couche d'oxyde en surface dudit empilement de couches de type semi-conducteur sur isolant, réalisée de manière à ce que dans le fond des cavités (315) le film d'oxyde formé s'étende au moins jusqu'à la couche isolante (114) ;
        • un retrait partiel du film d'oxyde de manière à mettre à nu la couche semi-conductrice initiale (312) en dehors de la cavité (315) et à conserver une partie au moins du film d'oxyde dans la cavité (315) pour laisser en place un plot d'oxyde (311) s'étendant depuis la couche isolante (114);

    - la formation d'une couche additionnelle en matériau semi-conducteur (313) recouvrant le plot d'oxyde (311) et destinée à former un canal (180) pour le transistor (200);
    - la formation d'un empilement de grille (160) au dessus du plot d'oxyde (311);
    - la formation d'une source et d'un drain (140) de part et d'autre de l'empilement de grille (160).

2. Procédé selon la revendication précédente dans lequel la formation du plot d'oxyde (311) est effectuée de manière à ce que la largeur L du plot d'oxyde (311) soit supérieure ou égale à la largeur Lg de l'empilement de grille (160), dans lequel l'empilement de grille (160) est formé par lithographie et dans lequel la formation du plot d'oxyde (311) est de préférence effectuée de manière à ce que : L ≥ Lg + 2 x Des, L étant la largeur L du plot d'oxyde (311), Lg étant la largeur de l'empilement de grille (160) et Des étant l'imprécision maximale de désalignement de la lithographie.

3. Procédé selon l'une quelconque des revendications précédentes dans lequel le retrait partiel du film d'oxyde effectué de manière à mettre à nu la couche semi-conductrice initiale (312) en dehors de la cavité (315) et à conserver une partie au moins du film d'oxyde dans la cavité (315) comprend une étape de gravure de type mécanique et chimique avec arrêt sur la couche semi-conductrice initiale (312).

4. Procédé selon l'une quelconque des revendications précédentes dans lequel la couche additionnelle en matériau semi-conducteur (313) recouvrant le plot d'oxyde (311) et destinée à former un canal (180) pour le transistor (200) est une couche de matériau semi-conducteur monocristallin.

5. Procédé selon l'une quelconque des revendications précédentes dans lequel la formation de la couche additionnelle en matériau semi-conducteur (313) recouvrant le plot d'oxyde (311) et destinée à former un canal (180) pour le transistor (200) comprend le report d'une couche en matériau semi-conducteur (313) cristallin sur le plot d'oxyde (311) et dans lequel le report de la couche additionnelle en matériau semi-conducteur (313) est de préférence effectué par un procédé comprenant le détachement d'un film mince de matériau semi-conducteur monocristallin par rupture d'une couche plus épaisse au niveau d'une zone de fragilisation d'un substrat de matériau semi-conducteur monocristallin.

6. Procédé selon l'une quelconque des revendications 1 à 4 dans lequel la couche semi-conductrice initiale (312) est cristalline et dans lequel la formation d'une couche additionnelle en matériau semi-conducteur (313) recouvrant le plot d'oxyde (311) et destinée à former un canal (180) pour le transistor (200) comprend :

- le dépôt d'une couche en matériau semi-conducteur (313) amorphe sur la couche semi-conductrice initiale (312) et le plot d'oxyde (311),
- un traitement thermique effectué de manière à cristalliser la couche en matériau semi-conducteur (313) amorphe par épitaxie en phase solide à partir de la couche semi-conductrice initiale (312).

7. Procédé selon l'une quelconque des revendications 1 à 6 dans lequel la formation d'une source et d'un drain (140) comprend :

- une gravure (520, 540) d'au moins de la couche additionnelle en matériau semi-conducteur (313) de manière à retirer au moins une portion de l'épaisseur de la couche additionnelle en matériau semi-conducteur (313) qui n'est pas située sous l'empilement de grille (160) et de manière à conserver une partie au moins de la couche additionnelle en matériau semi-conducteur (313) au niveau du canal (180) du transistor (200);
- une croissance (530) des zones de source et drain (140) par épitaxie à partir du matériau semi-conducteur restant en place.

8. Procédé selon la revendication précédente dans lequel ladite gravure (520, 540) d'au moins la couche additionnelle en matériau semi-conducteur (313) est une gravure anisotrope dont la direction privilégiée de gravure est perpendiculaire au plan du substrat (112) et dans lequel la croissance (530) des zones de source et drain (140) par épitaxie est de préférence amorcée à partir du matériau semi-conducteur formant le canal (180).

9. Procédé selon l'une quelconque des deux revendications précédentes dans lequel ladite gravure (520) d'au moins la couche additionnelle en matériau semi-conducteur (313) retire, de part et d'autre de l'empilement de grille (160), toute l'épaisseur de la couche additionnelle en matériau semi-conducteur (313) et toute l'épaisseur de la couche semi-conductrice initiale (312).

10. Procédé selon l'une quelconque des revendications 7 ou 8 dans lequel ladite gravure (540) conserve, de part et d'autre de l'empilement de grille (160), un film formé par une portion au moins de l'épaisseur de la couche semi-conductrice initiale (312) et éventuellement par une portion de la couche additionnelle en matériau semi-conducteur (313).

11. Procédé selon l'une quelconque des revendications précédentes dans lequel la formation (210) d'au moins une cavité (315) est réalisée par gravure d'une partie seulement de l'épaisseur de la couche semi-conductrice initiale (312) dans le fond des cavités (315) de manière à conserver une couche semi-conductrice ininterrompue à la surface de la couche isolante (114) et dans lequel la formation (220) d'une couche d'oxyde en surface dudit empilement de couches de type semi-conducteur sur isolant est réalisée de préférence par oxydation de la couche semi-conductrice initiale (312) pour former un film d'oxyde continu sur la surface découverte de la couche semi-conductrice initiale (312).

12. Procédé selon l'une quelconque des revendications 1 à 10 dans lequel la formation (210) d'au moins une cavité (315) est réalisée par gravure de la totalité de l'épaisseur de la couche semi-conductrice initiale (312) dans le fond des cavités (315).

13. Procédé selon la revendication précédente dans lequel la formation (220) d'une couche d'oxyde en surface dudit empilement de couches de type semi-conducteur sur isolant est réalisée par un dépôt d'oxyde sur la toute surface dudit empilement de couches.

14. Procédé selon l'une quelconque des revendications précédentes dans lequel la formation d'au moins une cavité (315) dans la couche semi-conductrice initiale (312) par gravure comprend, préalablement à la gravure, une étape d'oxydation de la couche semi-conductrice initiale (312) dans les zones à graver et sur une épaisseur correspondant à l'épaisseur à graver.

15. Procédé selon l'une quelconque des revendications précédentes dans lequel la formation d'une source et d'un drain (140) est effectuée de manière à former la source et le drain (140) en partie au moins dans la cavité (315) et en partie au moins de part et d'autre du plot d'oxyde (311).

Figure 1

Figure 2

Formation d'une cavité dans une couche semi-conductrice initiale — 210

Formation d'une couche d'oxyde en surface de la structure obtenue à l'étape 210 — 220

Mise à nu de la couche semi-conductrice initiale en laissant en place un plot d'oxyde situé sur la couche isolante — 230

240

Formation d'une couche de matériau semi-conducteur recouvrant le plot d'oxyde :

310

Report d'une couche additionnelle de matériau semi-conducteur cristallin sur la couche semi-conductrice initiale et le plot d'oxyde

ou

Dépôt d'une couche additionnelle de matériau semi-conducteur amorphe sur la couche semi-conductrice initiale — 310

Recristallisation du Si amorphe de la couche additionnelle — 320

Formation d'un empilement de grille au dessus du plot d'oxyde et sur la couche de matériau semi-conducteur — 250

Formation d'espaceurs recouvrant les flancs de l'empilement de grille — 260

270

Formation d'une source et d'un drain de part et d'autre de l'empilement de grille:

520

510

Dopage de la couche semi-conductrice

ou

Gravure avec mise à nu de la couche isolante de part et d'autre de la grille

ou

Gravure avec conservation d'un film semi-conducteur sur la couche isolante de part et d'autre de la grille — 540

Formation de la source et du drain par épitaxie — 530

**Figure 3**

315    315

312

114

112

**FIGURE 4a**

315    315

312

114

112

**FIGURE 4b**

317    315    315

312

312

114

112

**FIGURE 5**

316

311    312    311

312

312

114

112

**FIGURE 6**

**FIGURE 7a**

**FIGURE 7b**

**FIGURE 7c**

**FIGURE 8**

**FIGURE 9**

**FIGURE 10a**

200
126
410      410            410
124
132
311                     311
131
146
114
112

**FIGURE 10b**

126
410
124
132
131
117      180      117
311
114
112

**FIGURE 11a**

200
126
410            200
124
132
311      131            311
180
140      140      140
114
112

**FIGURE 11b**

126
410
124
132
131
180

311

311

146
114
112

**FIGURE 12a**

126
410
124
132
131
140

180

180

311

311

140

140

114
112

**FIGURE 12b**

Europäisches
Patentamt

European
Patent Office

Office européen
des brevets

**RAPPORT DE RECHERCHE EUROPEENNE**

Numéro de la demande

EP 14 15 4715

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 6 468 880 B1 (LIM YEOW KHENG [SG] ET AL) 22 octobre 2002 (2002-10-22) * abrégé * * colonne 2, ligne 65 - colonne 4, ligne 42 * * figures 1-6 * | 1-15 | INV. H01L21/84 H01L29/786 H01L21/762 |
| A | DE 101 45 699 A1 (INFINEON TECHNOLOGIES AG [DE]) 10 avril 2003 (2003-04-10) * abrégé * * figures 4a-4x * * alinéas [0080] - [0109] * | 1-15 | |
| A | US 6 020 615 A (LEE DUCK-HYUNG [KR]) 1 février 2000 (2000-02-01) * abrégé * * figures 4a-4e * * colonne 4, ligne 61 - colonne 6, ligne 14 * | 1-15 | |
| A | US 2006/022270 A1 (BOYD DIANE C [US] ET AL) 2 février 2006 (2006-02-02) * abrégé; figures 3b-3o * | 1-15 | DOMAINES TECHNIQUES RECHERCHES (IPC) H01L |

Le présent rapport a été établi pour toutes les revendications

| Lieu de la recherche | Date d'achèvement de la recherche | Examinateur |
|---|---|---|
| Berlin | 15 mai 2014 | Morena, Enrico |

CATEGORIE DES DOCUMENTS CITES

X : particulièrement pertinent à lui seul
Y : particulièrement pertinent en combinaison avec un
     autre document de la même catégorie
A : arrière-plan technologique
O : divulgation non-écrite
P : document intercalaire

T : théorie ou principe à la base de l'invention
E : document de brevet antérieur, mais publié à la
     date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 14 15 4715

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

15-05-2014

| Document brevet cité au rapport de recherche | | Date de publication | Membre(s) de la famille de brevet(s) | | Date de publication |
|---|---|---|---|---|---|
| US 6468880 | B1 | 22-10-2002 | SG | 99390 A1 | 27-10-2003 |
| | | | US | 6468880 B1 | 22-10-2002 |
| DE 10145699 | A1 | 10-04-2003 | AUCUN | | |
| US 6020615 | A | 01-02-2000 | JP | 3484320 B2 | 06-01-2004 |
| | | | JP | H1056183 A | 24-02-1998 |
| | | | US | 6020615 A | 01-02-2000 |
| | | | US | 6232155 B1 | 15-05-2001 |
| US 2006022270 | A1 | 02-02-2006 | CN | 1728402 A | 01-02-2006 |
| | | | JP | 5041685 B2 | 03-10-2012 |
| | | | JP | 2006049897 A | 16-02-2006 |
| | | | US | 2006022270 A1 | 02-02-2006 |

EPO FORM P0460

Pour tout renseignement concernant cette annexe : voir Journal Officiel de l'Office européen des brevets, No.12/82